Europäisches Patentamt

**European Patent Office**

Office européen des brevets

(19)

(11) Publication number: **0 208 393**
**A1**

# EUROPEAN PATENT APPLICATION

(12)

(21) Application number: 86302992.2

(22) Date of filing: 21.04.86

(51) Int. Cl.⁴: **G 01 R 31/28**
**G 06 F 11/22**

(30) Priority: 02.05.85 GB 8511187

(43) Date of publication of application:
**14.01.87 Bulletin 87/3**

(84) Designated Contracting States:
**BE DE FR GB IT NL**

(71) Applicant: **INTERNATIONAL COMPUTERS LIMITED**
**ICL House**
**Putney, London, SW15 1SW(GB)**

(72) Inventor: **Hale, Stuart George**
**10 Dane Road**
**Denton Manchester M34 2HY(GB)**

(74) Representative: Guyatt, Derek Charles et al,
**STC Patents Edinburgh Way**
**Harlow Essex CM20 2SH(GB)**

(54) **Testing digital integrated circuits.**

(57) A digital integrated circuit is described, comprising a logic circuit (11) and a linear feedback shift register (12) for applying a pseudo-random sequence of test patterns to the inputs of the logic circuit. The number of stages in the register is greater than the number of inputs to the logic circuit. As a result, a test pattern which would otherwise be missing (e.g. all zeros) is produced as part of a longer test pattern, avoiding the need for loading the missing pattern separately into the register.

Fig. 1.

# TESTING DIGITAL INTEGRATED CIRCUITS

This invention relates to testing digital integrated circuits.

One known method of testing a digital integrated circuit is to use a pseudo-random number generator to produce a sequence of test patterns. These patterns are applied to the input of the circuit to be tested, and the output of the circuit is then observed and compared with the expected value. A convenient form of pseudo-random number generator is a linear feedback shift register, and it may conveniently be integrated on the same chip as the circuit to be tested.

For example, US Patent No. 3 961 252 describes an integrated circuit having registers which normally act as buffers for data and addresses. In a test mode, these registers are converted into linear feedback shift registers for generating test patterns. Alternatively, the registers can be converted into simple shift registers, connected together in series to allow data to be scanned serially into or out of the registers for diagnostic purposes.

One problem with a conventional linear feedback shift register is that the maximum length of its sequence is $2^n-1$ where n is the number of bits in the register; i.e. one of the possible n-bit patterns is missing. If the feedback is achieved by means of exclusive -OR gating, the missing pattern will be all-zeros; if it is achieved by equivalence gating (i.e. the inverse of exclusive -OR), then the missing pattern is all-ones.

This presents a problem since the all-zeros or all-ones pattern may be a vital part of the pattern sequence for testing certain types of circuit. The usual way of handling this is to load the missing pattern separately into the register, for example, by using the linear scan path mentioned above. However, this takes extra time and therefore slows down the test procedure.

The object of the present invention is therefore to provide an alternative way of overcoming the problem of missing patterns without slowing the operation.

SUMMARY OF THE INVENTION

According to the invention, there is provided a digital integrated circuit comprising a logic circuit having $n$ inputs, and a register operable as a linear feedback shift register for applying test patterns to the inputs, characterised in that the register has at least $n + 1$ stages, the outputs of only $n$ of the stages being connected to the inputs of the logic circuit.

It can be seen that, by using a shift register longer than the number of bits in the required test pattern, the missing pattern is produced as part of a larger pattern. The extra bit or bits in the shift register may be located at any position within the register, usually at the beginning or the end.

One embodiment of the invention will now be described by way of example with reference to the accompanying drawings.

BRIEF DESCRIPTION OF THE DRAWINGS

Figure 1 is a block diagram of an integrated circuit chip including a test pattern generator.

Figure 2 shows one bit cell of the test pattern generator in detail.

DETAILED DESCRIPTION

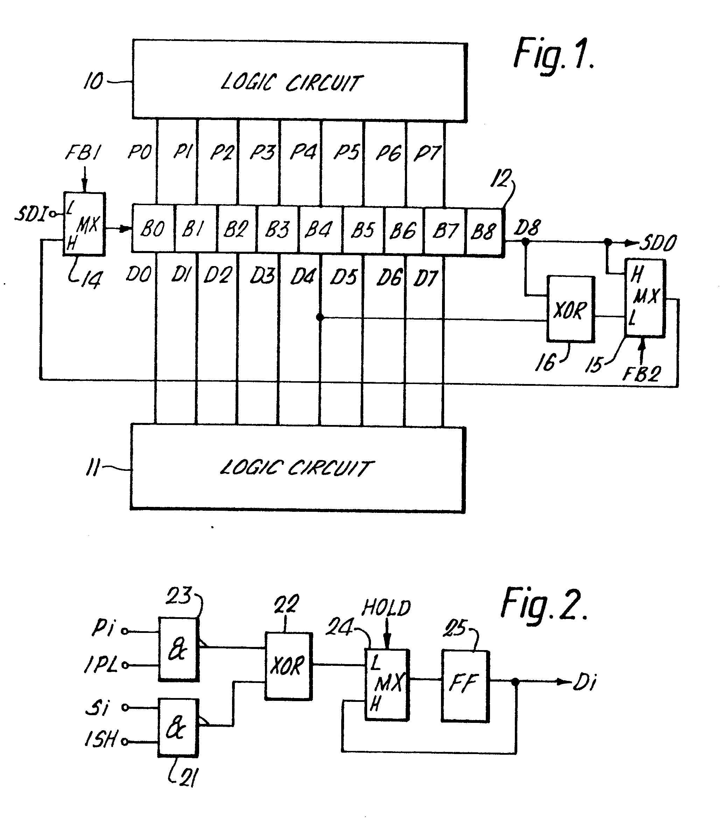

Referring to Figure 1, this shows an integrated circuit chip including logic circuits 10, 11, with a register 12 positioned between them. The circuit 10 produces an eight-bit output which is fed in parallel to data inputs PO-P7 of the register. The register has data outputs DO-D7 which are fed in parallel to the logic circuit 11, and also has an extra output D8.

The exact nature of the logic circuits 10, 11 forms no part of the present invention. For example, the circuit 10 may be an arithmetic unit and the circuit 11 may be a decoder. In other forms of the invention, the inputs PO-P7 may be connected directly to the external terminals of the chip, rather than being connected to a logic circuit.

The register 12 consists of nine bit cells B0-B8. The first eight cells B0-B7 act as an eight bit parallel buffer between the circuits 10, 11 and normal operation. The last cell, B8, is provided for use in test modes of operation as will be described. One of the bit cells $Bi$, where $i = 0,1 -8$, is shown in detail in Figure 2.

The cell has a serial data input $Si$ which is fed to a NAND gate 21, controlled by a signal ISH. The output of this gate is fed to one input of an exclusive -OR gate 22, the other input of which is connected to the output of a NAND gate 23. The gate 23 receives the parallel data input $Pi$ for the cell, and is controlled by a signal IPL.

Thus, when ISH is high and IPL is low, the output of gate 22 is equal to the data received at the serial input $Si$. When ISH is low and IPL high, the output of gate 22 is equal to the parallel data bit $Pi$. If both ISH and IPL are high, the output of the gate 22 is the exclusive -OR of the serial and parallel data inputs.

The output of the gate 23 is connected to one input of a multiplexer 24, the output of which is fed to the data input of a flip-flop (bistable circuit) 25. The output of the flip-flop is connected to the other input of the multiplexer 24, and also to the data output $Di$ of the cell.

The multiplexer 24 is controlled by a signal HOLD. When HOLD is high, the multiplexer selects the output of the flip-flop 25, causing its current contents to be fed back to its input. Thus, the flip-flop is held frozen in its current state, regardless of the condition of its input data signals. When HOLD is low, the multiplexer 24 selects the outputs of the exclusive -OR gate 22, and this allows either the serial input data, the parallel input data, or their exclusive -OR function to be clocked into the flip-flop 25.

The flip-flop 25 is a master-slave flip-flop controlled by a two-phase clock. Such flip-flops are well known and so it is not necessary to describe it in detail.

The control signals ISH, IPL and HOLD are common to all the cells B0-B8 in the register.

The data output $D_i$ of each bit cell is connected to the serial data input $S(i + 1)$ of the next cell, allowing the register to be operated as a shift register as will be described. The data output D8 of the last bit cell is connected to a serial data output terminal SDO.

The serial data input S0 of the first bit cell is connected to the output of a multiplexer 14 as shown in Figure 1. The multiplexer 14 is controlled by a signal FB1. When FB1 is low, the multiplexer selects a serial data input terminal SDI. When FB1 is high, it selects a feedback signal F8, from another multiplexer 15. The multiplexer 15 is controlled by a signal FB2. When FB2 is high, it selects the output D8 from the last bit cell in the register. When FB2 is low, it selects the output of an exclusive -OR circuit 16. The inputs of the exclusive -OR circuit are connected to the data outputs of bit cells B4 and B8.

OPERATION

The register has a number of modes of operation, controlled by the signals HOLD, IPL, ISH, FB1 and FB2 as follows:

| Mode | HOLD | IPL | ISH | FB1 | FB2 |
|------|------|-----|-----|-----|-----|
| HOLD | H | X | X | X | X |
| USER | L | H | L | X | X |
| SHIFT | L | L | H | L | X |
| SLIDE | L | L | H | H | H |
| GENERATE | L | L | H | H | L |
| ANALYSE | L | H | H | H | L |

In the HOLD mode, since the signal HOLD is high, the contents of all the bit cells are frozen and cannot be shifted or overwritten. In all the other modes, HOLD is low.

The USER mode is the normal mode of operation, when the register is serving its normal function as a parallel input/output buffer between the logic circuits 10, 11. In this mode, IPL is high and ISH low and hence each bit cell $B_i$ selects its parallel data input $P_i$, allowing data to be loaded in parallel into the flip-flops 25 at each clock beat.

In the SHIFT mode, IPL is low and ISH high. Hence, each bit cell $B_i$ selects its serial data input $S_i$. Since FB1 is low, the multiplexer 14 selects the serial data input terminal SDI. Thus, in this mode, data is shifted serially through the register, between the terminals SDI and SDO. This mode can be used to load test data into the register 12, or to read out its contents for diagnostic purposes.

In the SLIDE mode, the signals IPL and ISH have the same values as in the SHIFT mode and so the register 12 again operates as a shift register. However, in this mode, the signals FB1 and FB2 are both held high, so that the multiplexers 14, 15 are switched to select the serial output from the last stage B8 as the serial input to B0. Hence, in this mode, the register is connected as a circular shift register, allowing its contents to be rotated. This mode is useful for producing sequences of sliding test patterns for the logic circuit 11. For example, if the register is initially loaded with the pattern 000000001, the SLIDE mode can be used to rotate this pattern so that the "1" appears successively in each bit position.

In the GENERATE mode, the signals ISH, IPL and FB1 all have the same values as in the SLIDE mode. However, in this case FB2 is held low. The multiplexers 14, 15 are therefore now set to select the output of the exclusive -OR circuit 16 as the serial input to the bit cell B0. Hence, in this mode, the register acts as a feedback shift register, for generating sequences of pseudo-random numbers, for use as test patterns for the logic circuit 11.

In the ANALYSE mode, the signals ISH, FB1 and FB2 are the same as in the GENERATE mode. However, in this case, IPL is held high. Thus, the input parallel data P0-P7 is combined in the exclusive -OR gates 22 with the shifting data within the register. In this mode, therefore, the register acts as a signature analyser, generating a digital signature from a sequence of parallel inputs from the logic circuit 10. This signature can then be read out, using the SHIFT mode, and used for diagnostic purposes to detect and identify faults in the logic circuit 10.

It can be seen that in the GENERATE mode, the 9-bit register B0-B8 runs through a maximum length pseudo-random sequence, containing $2^9 -1$ different patterns; the all-zeros pattern is missing. However, when the pattern 000000001 occurs, it provides the all-zeros pattern on the data output lines D0-D7. Thus, the addition of the extra bit B8 to the register allows the all-zeros pattern to be applied to the logic circuit 11 without having to load the pattern separately into the register.

Similarly, in the SLIDE mode, if a sliding "1" pattern is rotated through the register, when the "1" reaches B8 the other cells B0-B7 all held zero. Thus, the circuit 11 can be tested with a sliding "1" pattern and also with the all-zeros pattern, without having to reload the register.

In the above example, the extra bit cell B8 is provided solely for the purpose of enabling the missing pattern to be produced. However, in other embodiments of the invention, the extra bit cell may be used for other purposes in normal (i.e. non-test) operation. For example, it may form part of another register.

It will be appreciated that the invention can be applied to registers of any size. Where the register contains a different number of cells, the feedback connections through the exclusive -OR circuit 16 may different. For example, if the register has sixteen normal bit cells B0-B15 and an extra bit cell B16, the exclusive -OR gate 16 would be connected to the outputs of bit cells B13 and B16 only.

- 8 -

0208393

CLAIMS:-

1.      A digital integrated circuit comprising a logic circuit (11) having $n$ inputs, and a register (12) operable as a linear feedback shift register for applying test patterns to the inputs, characterised in that the register (12) has at least $n$ + 1 stages (B0-B8), the outputs of only $n$ of the stages being connected to the inputs of the logic circuit (11).

2.      A circuit according to Claim 1 wherein the register (12) is alternatively operable as a circular shift register with its serial data output (D8) connected to its serial data input (SO).

3.      A circuit according to Claim 1 or 2, including a further logic circuit (10) having outputs (P0-P7) connected to inputs of the respective stages of the register (12).

4.      A circuit according to Claim 3 wherein the register (12) is alternatively operable as a digital signature analyser for forming a digital signature characteristic of a sequence of outputs from the further logic circuit (10).

0208393

1/1

Fig.1.

LOGIC CIRCUIT

Fig.2.

European Patent
Office

**EUROPEAN SEARCH REPORT**

| DOCUMENTS CONSIDERED TO BE RELEVANT | | | EP 86302992.2 |
|---|---|---|---|
| Category | Citation of document with indication, where appropriate, of relevant passages | Relevant to claim | CLASSIFICATION OF THE APPLICATION (Int. Cl.4) |
| D,A | <u>US - A - 3 961 252</u> (EICHELBERGER)<br>* Fig. 1,2; abstract *<br><br>-- | 1 | G 01 R 31/28<br>G 06 F 11/22 |
| A | <u>US - A - 3 961 254</u> (CAVALIERE)<br>* Abstract *<br><br>---- | 1 | |

**TECHNICAL FIELDS SEARCHED (Int. Cl.4)**

G 01 R 15/00

G 01 R 31/00

G 06 F 11/00

H 03 K 19/00

The present search report has been drawn up for all claims

| Place of search | Date of completion of the search | Examiner |
|---|---|---|
| VIENNA | 30-09-1986 | KUNZE |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82